# EUROPEAN PATENT APPLICATION

(11) **EP 3 425 668 A1**
(43) Date of publication of application: **09.01.2019**
(21) Application number: 17180059.2
(22) Date of filing: 06.07.2017
(51) Int. Cl.: H01L 27/02

(54) **ELECTROSTATIC DISCHARGE PROTECTION DEVICE**

(71) Applicant: NXP B.V., 5656 AG Eindhoven (NL)
(72) Inventor: EFFING, Hermanus Johannes, 22529 Hamburg (DE)
(74) Representative: Hardingham, Christopher Mark

(57) **Abstract**

An electrostatic discharge (ESD) protection device (10), and an integrated circuit comprising the same, are described. The ESD protection device (10) comprises a power device (20) comprising a first control terminal (22), a first input terminal (24) and a first output terminal (26), wherein a voltage at the first control terminal (22) is controllable to switch the power device (20) between an on-state for conducting a current between the first input terminal (24) and the first output terminal (26), and an off-state for blocking a current between the first input terminal (24) and the first output terminal (26), wherein the power device (20) is configured for conduction between the first input terminal (24) and the first output terminal (24), in the off-state, when an applied voltage between the first input terminal (24) and the first output terminal (26) exceeds a first breakdown voltage (V_{bd}). The ESD device (10) also comprises a trigger device (30) comprising a second control terminal (32), a second input terminal (34) and a second output terminal (36), wherein the trigger device (30) is configured to operate in an off-state for blocking a current between the second input terminal (34) and the second output terminal (36), wherein the trigger device (30) is configured for conduction between the second input terminal (34) and the second output terminal (36), in the off-state, when an applied voltage between the second input terminal (34) and the second output terminal (36) exceeds a second breakdown voltage (V_{bd}'). The second input terminal (34) is connected to the first input terminal (24). The second output terminal (36) is connected to the first control terminal (22). The power device (20) and the trigger device (30) may be transistors. The second breakdown voltage (V_{bd}') of the trigger device (30) is lower than the first breakdown voltage (V_{bd}) of the power device (20).

## Description

### FIELD OF THE INVENTION

The present invention relates to an electrostatic discharge (ESD) protection device and to an integrated circuit including an electrostatic discharge protection device.

### BACKGROUND OF THE INVENTION

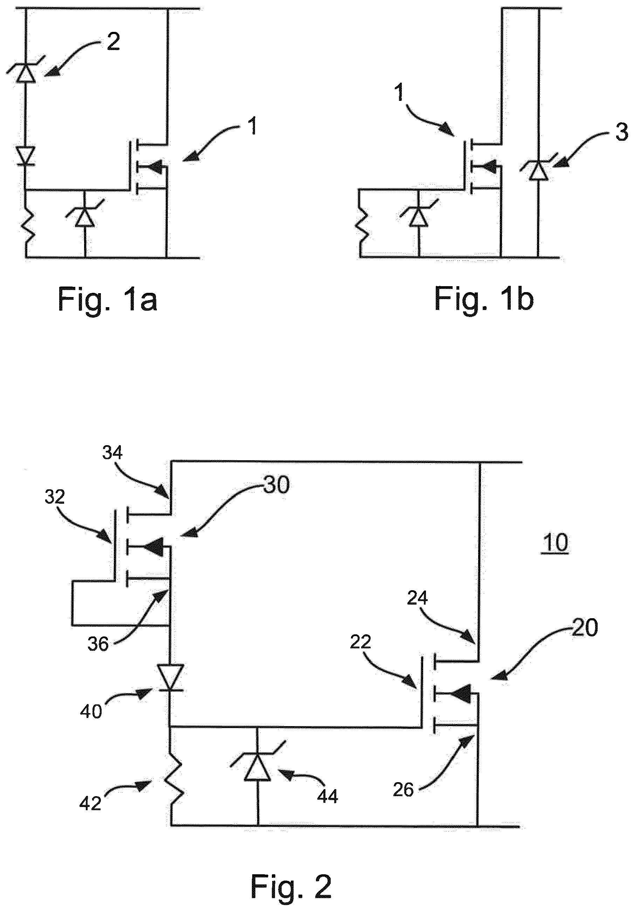

Many high voltage devices embedded in integrated circuit (IC) processes use an extended drain topology to realize the high voltage capability of the device. Active voltage clamping is an efficient method for protecting a high voltage device embedded in an IC process against over-voltage events, especially electrostatic discharge (ESD) events. Figure 1a illustrates an active voltage clamping circuit for protecting an extended drain MOSFET 1. Active voltage clamping involves using a trigger device 2 or circuitry to switch on the primary high voltage device 1 when its drain-source voltage V_{ds} approaches its breakdown voltage limit. This is in contrast to commonly-used parallel protection (shown in Figure 1b), in which a second device 3, connected in parallel to the primary high voltage device 1, limits the voltage on the primary high voltage device 1.

The active voltage clamping topology provides the benefit of smaller overall area, and thus lower cost, when compared with the parallel protection topology. This is partly because, in the parallel protection topology, the parallel-connected second device 3 needs sufficient device area to be able to absorb the excess energy associated with the ESD event or over-voltage. In contrast, in the active voltage clamping topology, the trigger device 2 can have a much smaller structure, as it only needs to provide the charge on the gate of the high voltage power device 1, while the excess energy is absorbed in the primary high voltage device 1. The primary high voltage device is generally sufficiently large (robust) to absorb the excess energy associated with ESD or over-voltage events without increasing the device size.

The active voltage clamp protection topology also ensures that the excess charge, resulting from an over voltage or ESD event, is handled by the power device 1 in its "on-state" as it is switched on during these situations. Generally, the power device 1 can handle more current in "on-state" compared to "off-state", thereby allowing a larger current (energy) density and a smaller device area for such protection in "on-state".

Typically, the trigger circuitry used for switching on the primary high voltage device in case of an over voltage or ESD event comprises a Zener diode 2 or a stack of Zener diodes, connected between the drain and gate of the primary high voltage device 1. Capacitors are often added to speed up switch-on on the primary high voltage device to improve the robustness of the ESD protection for fast ESD pulses.

### SUMMARY OF THE INVENTION

Aspects of the invention are set out in the accompanying claims. Combinations of features from the dependent claims may be combined with features of the independent claims as appropriate and not merely as explicitly set out in the claims.

According to an aspect of the invention, there is provided an electrostatic discharge (ESD) protection device, comprising:
a power device comprising a first control terminal, a first input terminal and a first output terminal, wherein a voltage at said first control terminal is controllable to switch the power device between an on-state for conducting a current between said first input terminal and said first output terminal, and an off-state for blocking a current between said first input terminal and said first output terminal, wherein said power device is configured for conduction between said first input terminal and said first output terminal, in said off-state, when an applied voltage between said first input terminal and said first output terminal exceeds a first breakdown voltage; and
a trigger device comprising a second control terminal, a second input terminal and a second output terminal, wherein said trigger device is configured to operate in an off-state for blocking a current between said second input terminal and said second output terminal, wherein said trigger device is configured for conduction between said second input terminal and said second output terminal, in said off-state, when an applied voltage between said second input terminal and said second output terminal exceeds a second breakdown voltage;
wherein said second input terminal is connected to said first input terminal; and said second output terminal is connected to said first control terminal;
wherein said second breakdown voltage of said trigger device is lower than said first breakdown voltage of said power device.

By ensuring that the breakdown voltage of the trigger device is lower than the breakdown voltage of the power device, the trigger device may be used to trigger switching on the power device in the event of an overvoltage. In the event of an over-voltage exceeding the breakdown voltage of the trigger device, the trigger device becomes conducting between its input and output terminals, generating a voltage at the control terminal of the power device. The power device thereby becomes conducting before its breakdown voltage is reached. This may also help to reduce the area overhead of the power device as is it is not required to withstand high overvoltages in its off-state.

Said second breakdown voltage of said trigger device may be correlated with the said breakdown voltage of said power device

This enables the power device to be operated at a voltage closer to its breakdown voltage. A problem with the active voltage clamping arrangement shown in Figure 1 a is that the respective breakdown voltages of both the Zener diode 2 and the high voltage transistor 1 show production spread, and are non-correlated as the devices are created using different process steps. This non-correlated production spread reduces the achievable operation voltage range of the high voltage device at the high end of the voltage range. By using a trigger device having a breakdown voltage correlated with the breakdown voltage of the power device, the operation voltage of the power device may be increased.

Said power device and said trigger device may be transistors.

Said power device and said trigger device may comprise the same type of transistor.

This feature may ensure that the breakdown voltages of the power device and trigger device are correlated.

Said power device and said trigger device may formed by the same process steps.

This feature may ensure that the breakdown voltages of the power device and trigger device are correlated. By forming the power device and trigger device by the same process, the power device and trigger device may have the same device structure.

Said first input terminal of said power device and said second input terminal of said trigger device may each be associated with a drift region.

This feature may be used to support the high voltage capability of the power device, and may also be used to scale the breakdown voltage of the trigger device relative to the breakdown voltage of the power device.

Said drift region of said second input terminal may be shorter than said drift region of said first input terminal.

This feature may be used to ensure that said second breakdown voltage of said trigger device is lower than said breakdown voltage of said power device.

The electrostatic discharge (ESD) protection device may further comprise a diode connected between said first control terminal and said first output terminal.

This diode, for example a Zener diode, may be used for limiting a voltage between said first control terminal and said first output terminal.

The electrostatic discharge (ESD) protection device may further comprise a resistance between said second output terminal and said first output terminal.

This feature may be used to scale the voltage generated at the first input terminal when the trigger device conducts a current between the second input and output terminals.

Said second control terminal may be connected to said second output terminal.

This feature may be used to configure the trigger device for operation in its off-state.

The power device may comprise a first field effect transistor, wherein said first control terminal, said first input terminal and said first output terminal comprise a first gate, a first drain and a first source respectively of said first field effect transistor; and said trigger device may comprise a second field effect transistor, wherein said second control terminal, said second input terminal and said second output terminal comprise a second gate, a second drain and a second source respectively of said second field effect transistor.

Implementing both the power device and trigger device as field effect transistors enables both devices to be created using the same process. This in turn enables the breakdown voltage of the trigger device to be correlated to the breakdown voltage of the power device, enabling the power device to be operated at a voltage closer to its breakdown voltage.

Each of said first field effect transistor and said second field effect transistor may have an extended drain.

An extended drain topology may be used to improve the high voltage capability of the power device. In addition, the length of extended drain may be determined based on the required breakdown voltage, and may therefore be used to scale the breakdown voltage of the trigger device.

Said extended drain of said first field effect transistor may be longer than said extended drain of said second field effect transistor.

This feature may be used to provide a lower breakdown voltage for the second field effect transistor than for the first field effect transistor.

Each of said power device and said trigger device may be a MOSFET.

Each of said power device and said trigger device may be an LDMOS transistor.

According to another aspect of the invention, there is provided plurality of electrostatic discharge (ESD) protection devices as defined above, wherein said second breakdown voltages of said trigger devices of said electrostatic discharge (ESD) devices are correlated with said first breakdown voltages of said corresponding power devices of said respective electrostatic discharge (ESD) devices.

According to another aspect of the invention, there is provided an integrated circuit comprising an electrostatic discharge (ESD) protection device as defined above.

According to another aspect of the invention, there is provided an electrostatic discharge (ESD) protection device, comprising:
a first field effect transistor comprising a first gate, a first drain and a first source, wherein a voltage at said first gate is controllable to switch the first field effect transistor between an on-state for conducting a current between said first gate and said first source, and an off-state for blocking a current between said first gate and said first source, wherein said first field effect transistor is configured for conduction between said first gate and said first source, in said off-state, when an applied voltage between said first gate and said first source exceeds a first breakdown voltage; and
a second field effect transistor comprising a second gate, a second drain and a second source, wherein said second field effect transistor is configured to operate in an off-state for blocking a current between said second drain and said second source, wherein said trig second field effect transistor is configured for conduction between said second gate and said second source, in said off-state, when an applied voltage between said second gate and said second source exceeds a second breakdown voltage;
wherein said second drain is connected to said first drain; and said second source is connected to said first gate;
wherein said second breakdown voltage is lower than said first breakdown voltage.

According to another aspect of the invention, there is provided a method for manufacturing an electrostatic discharge (ESD) protection device, comprising:
forming a power device comprising a first control terminal, a first input terminal and a first output terminal, wherein a voltage at said first control terminal is controllable to switch the power device between an on-state for conducting a current between said first input terminal and said first output terminal, and an off-state for blocking a current between said first input terminal and said first output terminal, wherein said power device is configured for conduction between said first input terminal and said first output terminal, in said off-state, when an applied voltage between said first input terminal and said first output terminal exceeds a first breakdown voltage; and
forming a trigger device comprising a second control terminal, a second input terminal and a second output terminal, wherein said trigger device is configured to operate in an off-state for blocking a current between said second input terminal and said second output terminal, wherein said trigger device is configured for conduction between said second input terminal and said second output terminal, in said off-state, when an applied voltage between said second input terminal and said second output terminal exceeds a second breakdown voltage;
forming a connection between said second input terminal and said first input terminal; and forming a connection between said second output terminal and said first control terminal;
wherein said second breakdown voltage of said trigger device is lower than said first breakdown voltage of said power device;
wherein the same process is used for forming each of said power device and said trigger device.

### BRIEF DESCRIPTION OF THE DRAWINGS

Embodiments of the present invention will be described, by way of example only, with reference to the accompanying drawings in which like reference signs relate to like elements and in which:
Figure 1 a shows an active voltage clamping circuit for ESD protection as known in the prior art;
Figure 1b shows a parallel protection circuit for ESD protection as known in the prior art;
Figure 2 shows an ESD protection circuit according to an embodiment of the invention;
Figure 3 illustrates an effect of (a) non-correlated and (b) correlated breakdown voltages of the power device and trigger device of an active voltage clamping circuit;
Figure 4 illustrates the current-voltage relationship for an extended drain MOSFET;
Figure 5 illustrates the response of the trigger device and power device in the circuit of Figure 2 to applied drain-source voltage; and
Figures 6a and 6b illustrate an extended drain transistor and a LDMOS transistor respectively.

### DETAILED DESCRIPTION

Figure 2 shows an ESD protection device according to an embodiment of the invention, in the form of an active voltage clamping circuit 10. The circuit 10 may be incorporated in an integrated circuit.

The circuit 10 shown in Figure 2 includes a power device 20, in the form of an extended drain n-channel MOSFET 20. An extended drain topology may be used, for example, to provide a high voltage capability for the power device 20. The power device 20 comprises a first control terminal 22 in the form of gate 22, a first input terminal 24 in the form of drain 24, and a first output terminal 26 in the form of source 26. A voltage V_{gs} applied between the gate 22 and source 26 is used to switch the device 20 between an on-state for conduction between the drain 24 and source 26, and an off-state for blocking conduction between the drain 24 and source 26. In the off-state, application of voltage V_{ds} between the drain 24 and source 26 greater than a breakdown voltage V_{bd} of the power device 20 results in non-destructive conduction between the drain 24 and source 26. The MOSFET 20 may be used, for example, for switching power to another device connected to the source 26 or drain 24.

The circuit 10 further includes a trigger device 30, in the form of an extended drain n-channel MOSFET 30. The trigger device 30 may be used to trigger the power device 20 to switch to its on-state in the event of an overvoltage at the drain 24 of the power device 20. An overvoltage is a voltage which approaches the breakdown voltage V_{bd} of the power device 20 for off-state drain-source conduction.

The trigger device 30 comprises a second control terminal 32 in the form of gate 32, a second input terminal 34 in the form of drain 34, and a second output terminal 36 in the form of source 36. The gate 32 and source 36 of the trigger device 30 are connected so that the applied voltage V_{gs}' between the gate 32 and source 36 is effectively zero, causing the trigger device 30 to remain in its off-state for blocking conduction between the drain 34 and source 36. In the off-state, application of voltage V_{ds}' between the drain 34 and source 36 of the trigger device 30 greater than a breakdown voltage V_{bd}' of the trigger device 30 results in non-destructive conduction between the drain 34 and source 36.

The second input terminal or drain 34 of the trigger device 30 is connected to the second input terminal or drain 24 of the power device 20. The second output terminal or source 36 of the trigger device 30 is connected via a diode 40 to the first control terminal or gate 22 of the power device 20. A resistor 42 and Zener diode 44 are connected in parallel between the gate 22 and source 26 of the power device 20. The resistor 42 limits current through the trigger device 30. The Zener diode 44 limits the voltage at the gate 22 of the power device 20.

When a voltage greater than the breakdown voltage V_{bd}' of the trigger device 30 appears at the drain 34 of the trigger device 30 (and thus also at the drain 24 of the power device 20), the trigger device 30 enters non-destructive breakdown and a current is conducted between the drain 34 and source 36 of the trigger device 30. This breakdown current flows through resistor 42, generating a voltage between the gate 22 and source 26 of the power device 20, so that the power device 20 is switched to its on-state and conducts current between its drain 24 and source 26. Energy associated with the overvoltage is thereby dissipated by the power device 20.

The breakdown voltage V_{bd}' of the trigger device 30 is lower than the breakdown voltage V_{bd} of the power device 20. Thus in the event of an overvoltage at the drain 24 of the power device 20, the trigger device 30 enters breakdown and switches on the power device 20, avoiding the power device 20 entering breakdown in its off-state. This helps to protect the power device 20 from damage due to over-voltage and other ESD events because the power device 20 can handle more current in its on-state than in its off-state.

The trigger device 30 can be much smaller than the power device 20 as it only has to provide the charge on the gate 22 of the power device 20, while the excess energy is absorbed by the power device 20. The power device 20 is typically sufficiently large to absorb the energy associated with overvoltage and other ESD events without any increase in size.

By using matched devices (i.e the same type of device) for the power device 20 and trigger device 30 (for example, both are extended drain MOSFETs in the embodiment shown in Figure 2), the breakdown voltages V_{bd} and V_{bd}' of the power device 20 and trigger device 30 may be correlated because the power device 20 and trigger device 30 are created using the same process steps and are subject to similar production spread. This enables the power device 20 to be operated at a higher voltage compared with the arrangement shown in Figure 1a, as will be explained in the following.

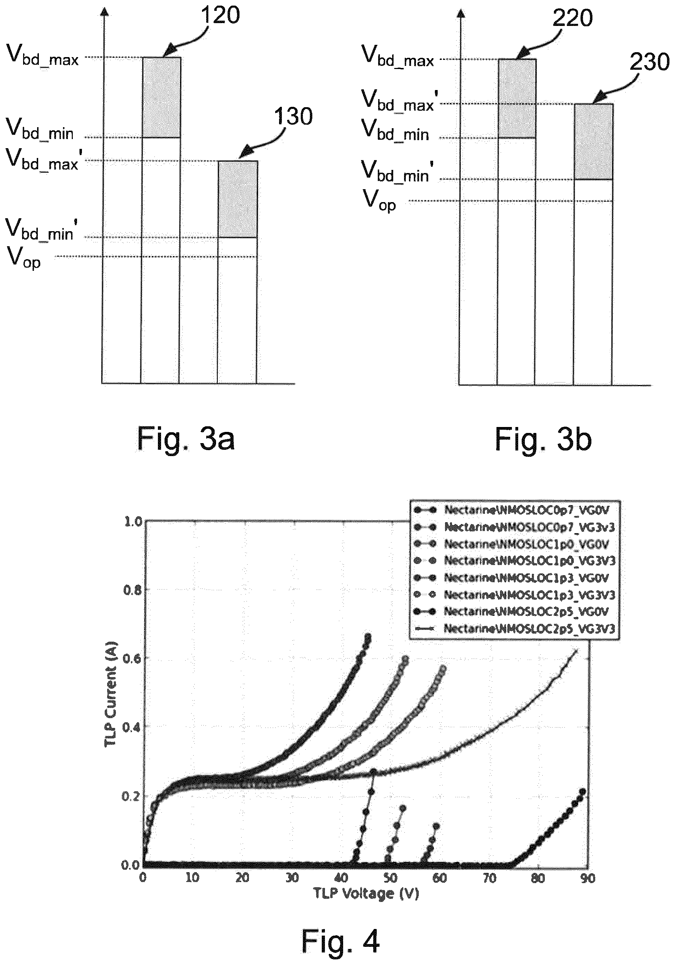

In the arrangement shown in Figure 1a, the breakdown voltages of both the Zener diode 2 and the power transistor 1 show production spread, but these breakdown voltages are non-correlated as the Zener diode 2 and the power transistor 1 are created using different process steps. This non-correlated production spread reduces the achievable maximum operation voltage of the power transistor 1. This is explained with reference to Figure 3, which illustrates the effect of correlated and non-correlated breakdown voltages of the power device and trigger device.

Figure 3a illustrates non-correlated breakdown voltages. The breakdown voltage V_{bd} of the power device 20 (left-hand bar 120) has a minimum value V_{bd_min} and a maximum value V_{bd_max} due to production spread. The breakdown voltage V_{bd}' of the trigger device 30 (right-hand bar 130) also has a minimum value V_{bd_min}' and a maximum value V_{bd_max}' due to production spread. In order to ensure that the trigger device 30 has a lower breakdown voltage than the power device 20, the breakdown voltage of the trigger device 30 must be specified so that its maximum value V_{bd_max}' is smaller than the minimum value V_{bd_min} of the breakdown voltage of the power device 20. The maximum guaranteed operation voltage Vₒₚ of the power device 20 must then be specified at a value smaller than the minimum breakdown voltage V_{bd_min}' of the trigger device 30. As can be seen from Figure 3a, this sets the guaranteed operation voltage Vₒₚ of the power device 20 significantly lower than the minimum breakdown voltage V_{bd_min} of the power device 20.

Figure 3b illustrates correlated breakdown voltages, as implemented in the present disclosure. Now that the breakdown voltages of the power device 20 (left-hand bar 220) and trigger device 30 (right-hand bar 230) are correlated, the breakdown V_{bd}' of the trigger device 30 may be specified at a higher value than in the non-correlated case and its maximum value V_{bd_max}' may be greater than the minimum breakdown voltage V_{bd_min} of the power device 20. Of course, the maximum value V_{bd_max}' of the breakdown voltage of the trigger device 30 must smaller than the maximum value V_{bd_max} of the breakdown voltage of the power device 20, and the minimum value V_{bd_min}' of the breakdown voltage of the trigger device 30 must be smaller than the minimum value V_{bd_min} of the breakdown voltage of the power device 20. However, it can be seen from Figure 3b that the resulting maximum guaranteed operation voltage Vₒₚ of the power device 20, specified at a value less than the minimum breakdown voltage V_{bd_min}' of the trigger device 30, is higher in the correlated case (Figure 3b) than in the non-correlated case (Figure 3a).

It can therefore be seen that using a trigger device 30 with a breakdown voltage V_{bd}' correlated with the breakdown voltage V_{bd} of the power device 20 allows the maximum operation voltage Vₒₚ of the power device 20 to be increased so that it is closer to the breakdown voltage V_{bd} of the power device 20.

The extended drain topology of the MOSFETs 20, 30 included in the embodiment shown in Figure 2 provides a means for scaling the breakdown voltages, as the breakdown voltage of the MOSFET depends on the length of the extended drain structure. This is an experimentally proven result as illustrated by the test data shown in Figure 4, which show drain-source voltage when applying a pulsed drain-source current for example MOSFETs having extended drains of different lengths. The four upper curves in Figure 4 show drain-source current vs drain-source voltage in the on-state. The four lower curves in Figure 4 show drain-source current vs drain-source voltage in the off-state. For each set of curves (on-state, off-state), the length of the drift region of the drain increases from the left-most curve to the right-most curve. The breakdown voltage for drain-source conduction in the off-state is indicated by the sharp increase in current in the lower curves, and increases with increasing length of the extended drain or drift region.

Thus the trigger device 30 of the circuit 10 may be implemented by an extended drain device with a shorter extended drain length than that of the power device 20. This ensures a lower breakdown voltage for the trigger device 30 than for the power device 20. A high level of correlation between the breakdown voltages of the trigger device 30 and power device 20 is ensured as they are created with the same device structure and process steps, resulting in correlated production spread.

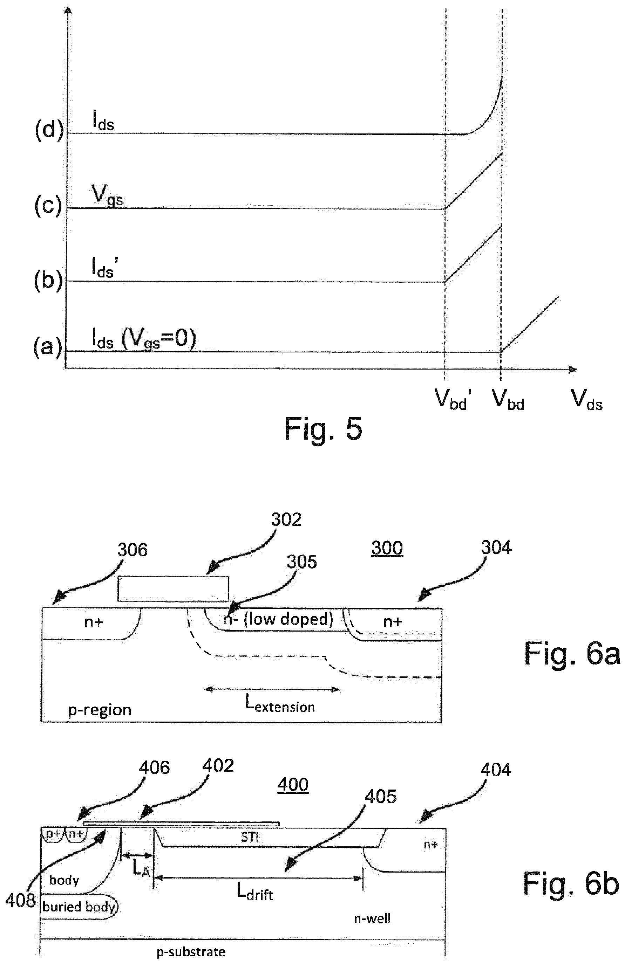

Figure 5 illustrates the response of the circuit of Figure 2 to an applied drain-source voltage V_{ds}. The curve (a) shows drain-source current I_{ds} vs drain-source voltage V_{ds} for the power device 20 in its off-state and indicates breakdown at a first drain-source breakdown voltage V_{bd}, at which point the drain-source breakdown current begins to flow, increasing with increasing applied voltage. The curve (b) shows the corresponding drain-source current I_{ds}' vs drain-source voltage V_{ds}' for the trigger device 30 in its off-state and indicates breakdown at a second drain-source breakdown voltage V_{bd}' which is specified at a lower value than the breakdown voltage V_{bd} of the power device 20. When a drain-source current I_{ds}' is conducted by the trigger device 30 in breakdown, the gate-source voltage V_{gs} of the power device 20 increases accordingly, as shown by curve (c) of Figure 5. The increase in gate-source voltage V_{gs} causes the power device 20 to be switched to its on-state, and the power device 20 starts to conduct a drain-source current I_{ds} in its on-state, as indicated by curve (d) of Figure 5. Thus, starting with the power device 20 in its off-state, an overvoltage event results in the power device 20 being switched to its on-state (conducting state) before its drain-source breakdown voltage is reached. The power device 20 thereby dissipates the excess energy associated with the overvoltage event in its on-state, helping to avoid damage.

Figures 6a and 6b illustrate a drain extended metal oxide semiconductor transistor and an LDMOS (laterally-diffused metal oxide semiconductor) transistor respectively, each of which are suitable for use as both the power device and trigger device in the present invention. The extended drain transistor 300 shown in Figure 6a comprises a gate 302, drain 304, source 306, and an n- drain extension 305. When a high voltage is applied to the drain 304, the voltage is dropped along the length Lₑₓₜₑₙₛᵢₒₙ of the extended drain region 305. The breakdown voltage increases with the length Lₑₓₜₑₙₛᵢₒₙ of the extended drain region 305. The LDMOS transistor 400 with shallow-trench isolation (STI) shown in Figure 6b comprises a gate 402, drain 404 and source 406. An applied voltage is dropped across a drift region 405 between the external drain 404 and the internal channel 408 of the transistor 400. The breakdown voltage of the transistor increases with the length L_{drift} of the drift region 405.

The skilled person will appreciate that the invention is applicable to power/trigger devices having structures other than those described above. The breakdown voltages of the power device and trigger device are correlated, enabling the power device to be operated at a voltage higher than in the non-correlated case. Correlation of the respective breakdown voltages may be achieved by implementing the trigger device and power device using the same device structure, so that they are created using the same process steps, resulting in correlated production spread. Thus any power device requiring a trigger voltage to be switched to its on-state may be used. For example, the power device 20 described above may be substituted by an IGBT, provided that the trigger device 30 is also substituted by an IGBT. The power/trigger devices described above may be substituted by other types of transistor, including other types of field effect transistors and bipolar transistors. In particular, any device having an extended drain or a drift region, such as extended drain MOSFETs and laterally diffused MOS (LDMOS), provide a useful means for scaling the relative breakdown voltages of the power device and trigger device. In devices such as LDMOS, in which voltage is dropped along a drift region, a longer drift region is used to obtain a higher breakdown voltage of the device.

Accordingly there has been described an electrostatic discharge (ESD) protection device, and an integrated circuit comprising the same. The ESD protection device comprises a power device comprising a first control terminal, a first input terminal and a first output terminal, wherein a voltage at the first control terminal is controllable to switch the power device between an on-state for conducting a current between the first input terminal and the first output terminal, and an off-state for blocking a current between the first input terminal and the first output terminal, wherein the power device is configured for conduction between the first input terminal and the first output terminal, in the off-state, when an applied voltage between the first input terminal and the first output terminal exceeds a first breakdown voltage. The ESD device also comprises a trigger device comprising a second control terminal, a second input terminal and a second output terminal, wherein the trigger device is configured to operate in an off-state for blocking a current between the second input terminal and the second output terminal, wherein the trigger device is configured for conduction between the second input terminal and the second output terminal, in the off-state, when an applied voltage between the second input terminal and the second output terminal exceeds a second breakdown voltage. The second input terminal is connected to the first input terminal and the second output terminal is connected to the first control terminal. The second breakdown voltage of the trigger device is lower than the first breakdown voltage of the power device.

Although particular embodiments of the invention have been described above, it will be appreciated than many modifications, including additions and/or substitutions, may be made within the scope of the appended claims.

## Claims

1. An electrostatic discharge (ESD) protection device, comprising:
a power device comprising a first control terminal, a first input terminal and a first output terminal, wherein a voltage at said first control terminal is controllable to switch the power device between an on-state for conducting a current between said first input terminal and said first output terminal, and an off-state for blocking a current between said first input terminal and said first output terminal, wherein said power device is configured for conduction between said first input terminal and said first output terminal, in said off-state, when an applied voltage between said first input terminal and said first output terminal exceeds a first breakdown voltage; and
a trigger device comprising a second control terminal, a second input terminal and a second output terminal, wherein said trigger device is configured to operate in an off-state for blocking a current between said second input terminal and said second output terminal, wherein said trigger device is configured for conduction between said second input terminal and said second output terminal, in said off-state, when an applied voltage between said second input terminal and said second output terminal exceeds a second breakdown voltage;
wherein said second input terminal is connected to said first input terminal; and said second output terminal is connected to said first control terminal;
wherein said second breakdown voltage of said trigger device is lower than said first breakdown voltage of said power device.

2. An electrostatic discharge (ESD) protection device according to claim 1, wherein said second breakdown voltage of said trigger device is correlated with said first breakdown voltage of said power device.

3. An electrostatic discharge (ESD) protection device according to claim 1 or claim 2, wherein said power device and said trigger device comprise the same type of transistor.

4. An electrostatic discharge (ESD) protection device according to any one of the preceding claims, wherein said power device and said trigger device are formed by the same process steps.

5. An electrostatic discharge (ESD) protection device according to any one of the preceding claims, wherein said first input terminal of said power device and said second input terminal of said trigger device each is associated with a drift region.

6. An electrostatic discharge (ESD) protection device according to claim 5, wherein said drift region of said second input terminal is shorter than said drift region of said first input terminal.

7. An electrostatic discharge (ESD) protection device according to any one of the preceding claims, further comprising a diode connected between said first control terminal and said first output terminal.

8. An electrostatic discharge (ESD) protection device according to any one of the preceding claims, further comprising a resistance between said second output terminal and said first output terminal.

9. An electrostatic discharge (ESD) protection device according to any of the preceding claims, wherein:
said power device comprises a first field effect transistor, wherein said first control terminal, said first input terminal and said first output terminal comprise a first gate, a first drain and a first source respectively of said first field effect transistor;
said trigger device comprises a second field effect transistor, wherein said second control terminal, said second input terminal and said second output terminal comprise a second gate, a second drain and a second source respectively of said second field effect transistor.

10. An electrostatic discharge (ESD) protection device according to claim 9, wherein each of said first field effect transistor and said second field effect transistor has an extended drain.

11. An electrostatic discharge (ESD) protection device according to claim 10, wherein said extended drain of said first field effect transistor is longer than said extended drain of said second field effect transistor.

12. An electrostatic discharge (ESD) protection device according to any one of the preceding claims, wherein each of said power device and said trigger device is a MOSFET.

13. An electrostatic discharge (ESD) protection device according to any one of the preceding claims, wherein each of said power device and said trigger device is an LDMOS transistor.

14. An integrated circuit comprising an electrostatic discharge (ESD) protection device according to any one of the preceding claims.

15. A plurality of electrostatic discharge (ESD) protection devices according to any one of claims 1 to 14, wherein said second breakdown voltages of said trigger devices of said electrostatic discharge (ESD) devices are correlated with said first breakdown voltages of said corresponding power devices of said respective electrostatic discharge (ESD) devices.
